# EUROPEAN PATENT APPLICATION

(11) **EP 4 844 099 A1**
(43) Date of publication of application: **25.11.2026**
(21) Application number: 26178854.1
(22) Date of filing: 15.05.2026
(51) Int. Cl.: C23C 16/455

(54) **GAS INJECTION APPARATUS**

(30) Priority: 20.05.2025 IT 202500011380
(71) Applicant: LPE S.p.A., 20021 Baranzate (MI) (IT)
(72) Inventor: MESCHIA, Maurilio, Asti (IT)
(74) Representative: Buzzi, Notaro & Antonielli d'Oulx S.p.A.

(57) **Abstract**

An injection apparatus for delivering one or more gases inside a reaction chamber for the deposition of films on a substrate, the injection apparatus comprising: (i) a first conduit comprising at least a first gas injection component, and (ii) a second conduit fluidically connected to the first conduit and having a hollow body extending along a longitudinal direction X; (iii) at least one diffusion plate. The invention also related to a method for operating the injection apparatus, a reaction chamber comprising said injection apparatus, and a reactor comprising said reaction chamber.

## Description

### FIELD OF INVENTION

The present invention relates to the field of integrated circuit fabrication.

More specifically, the invention relates to a gas injection apparatus for a reaction chamber for the deposition of films on a substrate, a method for operating the injection apparatus, a reaction chamber comprising said injection apparatus, and a reactor comprising said reaction chamber.

### BACKGROUND OF THE DISCLOSURE

As the requirements of integrated circuit fabrication become more and more stringent due to the challenges in device scaling and the challenges in economic considerations, improved quality of deposited films on substrates, and simplification of substrate handling processes, have been gaining increasing importance.

For a number of processes used in the film deposition industry, mixing of reactant gases may be extremely important. This is due to various reasons, one of which may be related to the fact that the characteristics of the process gases reaching the substrates are critical to achieve uniform film deposition.

In view of the growing importance of film quality, mixing of gases may thus become more critical in semiconductor manufacturing in the making of future generation devices.

In some cases, such as described in patent application WO2022053963, the injection apparatus is preceded by an assembly for introducing gaseous mixtures into a reaction chamber. The assembly is adapted to be placed before the reaction chamber and comprises two partitions which define, together with the walls of the apparatus, three small chambers adapted to guide the flows of a first gaseous mixture (centrally) and of a second gaseous mixture (on both sides respectively). Each of the three small chambers may be fluidically connected to a "source" of gaseous mixture. The "partitioned" gas introducing assembly is arranged so that the gaseous mixtures do not substantially mix before reaching the substrate.

The above solution allows to tailor the spatial distribution of gaseous mixtures with respect to a substrate, and specifically, to distinguish the gaseous mixture reaching the center from the one reaching the sides.

However, the walls of the apparatus prevent a user or a robot from uploading/downloading a substrate to be treated on the clean side of the chamber, i.e., the upstream side, where the injection of gases occurs.

Furthermore, adjacent gas mixtures may diverge upon exiting the injection apparatus and entering the reaction chamber, which might cause turbulence and/or mixing. These undesired effects increase if the speed of the two or more gas mixtures differ from each other.

There is, therefore, a need in the art to provide an improved gas injection apparatus, a method for operating said injection apparatus, a reaction chamber comprising said injection apparatus, and a reactor comprising said reaction chamber.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It is an object of the present invention to overcome the disadvantages of the prior art. In particular, it is an object of the present invention to provide an improved gas injection apparatus.

More specifically, it may be an objective to provide an injection apparatus enabling to upload a substrate in a reaction chamber at the upstream side of the chamber, without removing the injection apparatus. It may be a further objective to achieve this effect while improving the speed uniformity of process gases along the plane perpendicular to their direction of flow.

To at least partially achieve this goal, the present disclosure may provide an injection apparatus, a method for operating said injection apparatus, a reaction chamber comprising said injection apparatus, and a reactor comprising said reaction chamber, as defined in the independent claims, which constitute an integral part of the present description.

Further embodiments of the gas injector and the vertical furnace are provided in the dependent claims. Further and alternative objectives may be understood from the following.

It is noted that the use of reference signs in the claims does not limit their scope. The sole purpose of reference signs is to make the claims easier to understand.

### BRIEF DESCRIPTION OF THE FIGURES

The illustrations presented herein are not meant to be actual views of any particular material, structure, or device, but are merely idealized representations that are used to describe embodiments of the disclosure.
FIG. 1 schematically illustrates a top view of an injection apparatus of the prior art in the XY plane.
FIG. 2 schematically illustrates a lateral view of an injection apparatus in the XZ plane, according to an embodiment of the invention.
FIG. 3 schematically illustrates a lateral view of an injection apparatus in the XZ plane, according to an embodiment of the invention.
FIG. 4 schematically illustrates a lateral view of an injection apparatus in the XZ plane, according to an embodiment of the invention.
FIG. 5 schematically illustrates a top view of part of an injection apparatus projected in the XY plane, according to an embodiment of the invention.
FIG. 6 schematically illustrates a top view of part of an injection apparatus projected in the XY plane, according to an embodiment of the invention.
FIG. 7 schematically illustrates a top view of part of the injection apparatus depicted in FIG. 6.
FIG. 8 schematically illustrates a lateral view of a reaction chamber in the XZ plane, according to an embodiment of the invention.
FIG. 9 presents a schematic axonometric view of a cropped section of a reaction chamber in the XYZ space, according to an embodiment of the invention.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Reference will now be made to the Figures wherein like reference numerals identify similar structural features or aspects of the subject disclosure. The same frame of cartesian coordinates (X, Y, Z) is used across all Figures.

It will be appreciated that elements in the figures are illustrated for simplicity and clarity. In particular some elements may have been omitted or may have not necessarily been drawn to scale. For example, the dimensions of some of the elements in the figures may be exaggerated relative to other elements to help improve understanding of illustrated embodiments of the present disclosure.

Under a first aspect, the present invention relates to an injection apparatus 10 for delivering one or more gases inside a reaction chamber for the deposition of films on a substrate.

The injection apparatus includes:
- a first conduit 100 provided with at least a first gas injection component 150, 152, 154 and
- a second conduit 200 fluidically connected to the first conduit, and having a hollow body extending along a longitudinal direction X, and
- at least one diffusion plate 205.

By "diffusion plate" it is meant an element, such as a porous partition, which ensures that a gas or gaseous mixture flowing through said plate exhibits a substantially uniform speed distribution downstream of the diffusion plate.

The first conduit is connected to the body of the second conduit so as to form an angle θ with respect to the second conduit, with 0 < θ < 180°.

The gas injection component(s) include one or more apertures (150a, 152a, 152b, 152c, 154a, 154b, 154c) for the injection of one or more gases inside the first conduit.

The first conduit is suitable for flowing the one or more gases into the second conduit, for example along at least one main path of gas flow F.

The at least one diffusion plate is positioned across the first conduit and downstream of at least one of the one or more apertures for the injection of one or more gases.

The body of the second conduit along the longitudinal direction X terminates on one side at a first end 200a, and on a second end 200b, on the other.

The second conduit is suitable for receiving the one or more gases from the first conduit and delivering them towards its first end along the longitudinal direction X.

The first end 200a may be fluidically connectable or connected to a reaction chamber 1.

Additionally, the second conduit is adapted for the displacement of one or more substrates between its first end and its second end.

To this effect, both the first end and the second end may be open, and/or each of the first end and the second end may comprise at least one opening suitable for the passage of a substrate and/or a substrate holder, and/or a robotic arm for handling substrates or substrate holders.

The angle "θ" refers to the non-reflex angle (i.e., an angle < 180°) between the second conduit and the first conduit, where they fluidically connect to each other. In case the second conduit and/or the first conduit are not substantially monodirectional, the angle is measured in regard to the respective tangents of the inner walls of the second conduit and first conduit. If this value is not constant, the angle θ is the average thereof.

The one or more gases mentioned herein may comprise any process gases, i.e., gases suitable for carrying out processes taking place in a reaction chamber for the deposition of films on a substrate.

For example, without limitation, the process gases may include any or all of the following: carrier gases, precursor gases of the films to be deposited, doping gases, purging gases, cleaning and/or etching gases. These gases may be single source or consist of a mixture of different elements.

Advantageously, the injection apparatus according to the invention allows to upload and download the substrates to be treated in a reaction chamber from its upstream side 1b, i.e., the "clean" side, even in case physical elements (such as diffusion plates and/or the separation plates discussed hereinafter) are used to improve and/or tailor relevant properties of the flow of gases, for example in terms of speed uniformity, relative composition and/or concentration.

The above result is possible because the substrates are displaced along a conduit (the second conduit) that is physically distinct from the partitioned conduit where the gas injection takes place (the first conduit). This allows to place in the first conduit any permanent physical encumbrance used to achieve an optimal gaseous profile (such as the diffusion plates), thereby leaving the second conduit clear from permanent partition elements which may hamper the transportation of substrates.

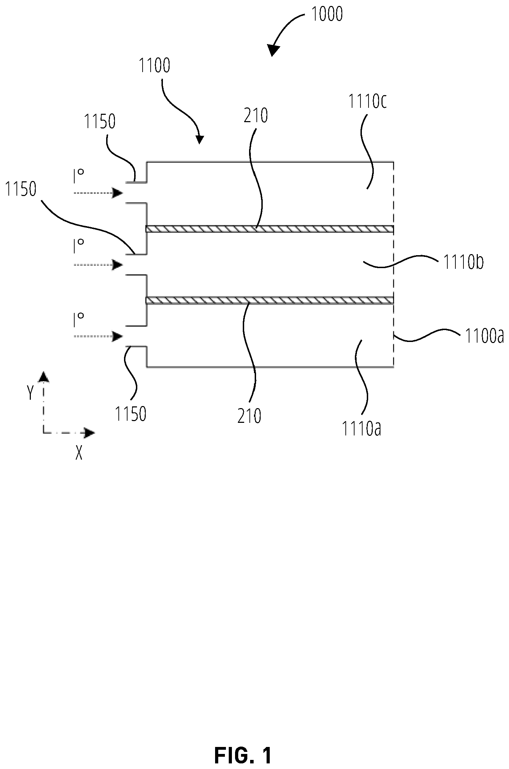

Contrary to the prior art injection system 1000 depicted in FIG. 1, the present invention may therefore provide an injection apparatus enabling the upload/download of a substrate in a reaction chamber 1 at the upstream side 1b of the chamber, without removing the injection apparatus. The operation may be conducted also in the presence of a substrate holder, and/or a handling robot, provided the sizes of these devices are taken into account in the design of the injection apparatus.

The diffusion plate may provide a uniform speed of the injected gases across the cross section of the first conduit.

The diffusion plate may be preferably chosen from porous, non-contaminating materials. For example, it can be made of porous quartz, ceramic or stainless steel.

In general, the use of a diffusion plate allows the gases to reach the first end of the injection apparatus with roughly uniform speed in the transverse Y direction perpendicular to the longitudinal direction X.

The injection apparatus may further include a gate valve 400 connected to the second end of the second conduit.

In general, both the first and second conduits are hollow bodies, by which it is meant they comprise one or more fluidically connected cavities, hollows, channels, etc.

The first conduit extends from an upstream end 100b to a downstream end 100a, and its shape determines the main direction of gas flow F between these two terminal points.

The upstream end 100b and/or the downstream end 100a may comprise an aperture or opening.

The first conduit 100 and the second conduit 200 may be fluidically connected in correspondence of the downstream end 100a of first conduit, through an opening in the body of the second conduit 200 and a corresponding opening at the downstream end 100a.

The first conduit and second conduit may be integral with each other.

In one embodiment, the injection apparatus 10 may further include:
- a plurality of gas injection components 150, 152, 154 sequentially placed along the first conduit 100, and
- a plurality of diffusion plates 205.

At least one diffusion plate is placed downstream of each gas injection component.

In this configuration, the gas injection components are placed consecutively one after the other, between the upstream end 100b and the downstream end 100a of the first conduit 100, and at least one diffusion plate 205 is interposed between every two consecutive gas injection components.

Each successive gas injection component 150, 152, 154 is positioned downstream with respect to the preceding one, thereby forming a sequence of enclosures (171, 172, 173) fluidically connected in series, via the diffusion plates 205, along the first conduit; i.e., along the main direction of gas flow F towards the second conduit 200.

Each enclosure is delimited by the internal walls of the first conduit, or a portion thereof, and one or more diffusion plates.

Each gas injection component includes one or more apertures (150a, 152a, 152b, 152c, 154a, 154b, 154c) for the injection of one or more gases, and each gas injection component is adapted to inject one or more gases into one enclosure.

Advantageously, this configuration allows each first gas injection component to deliver a specific gas composition into a specific enclosure. Each gas composition may comprise or consist of any of the following: carrier gases, precursor gases of the film to be deposited, doping gases, purging gases, cleaning and/or etching gases.

The expression "gas composition" shall be interpreted as a gaseous component, or gaseous input, which may include a single gaseous element (such as Ar, H₂, Ne, etc.) or a plurality of elements.

In the present embodiment, each gas composition may enter into a specific enclosure and flow towards the first conduit with uniform distribution after passing through the diffusion plate.

In one embodiment, the injection apparatus 10 may also include at least one separation plate 210.

In the present embodiment, at least one gas injection component 152 (and/or 154) includes at least two apertures 152a, 152b, 152c (and/or 154a, 154b, 154c) placed in correspondence of one same enclosure 172 (173).

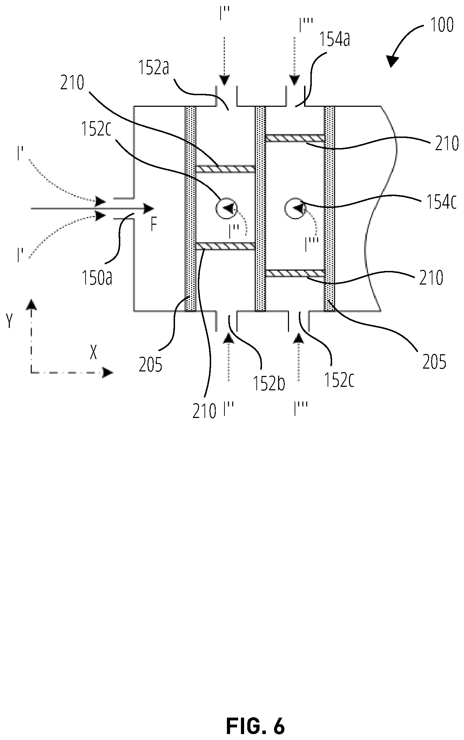

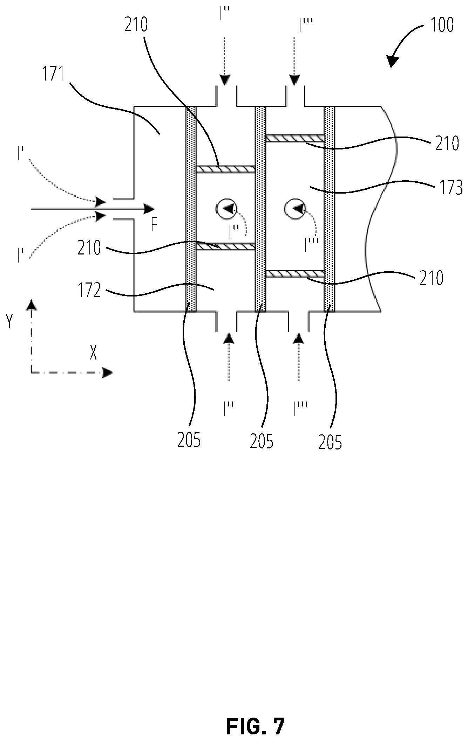

At least one separation plate 210 is arranged into the enclosure 172 (173) so as to fluidically segregate the apertures 152a, 152b, 152c (and/or 154a, 154b, 154c) from each other (see FIG. 6 and FIG. 7)

By separation plate it is meant a partition element adapted to prevent the gaseous contents injected within one same enclosure, albeit through different apertures, from mixing with each other.

In a non-limiting example, the separation plate may be made of quartz, ceramic, or stainless steel.

Advantageously, this configuration allows to separate an enclosure into a plurality of sub-enclosures, which may receive different compositions, or the same gas composition (which may be delivered in each sub-enclosure with different relative concentrations of its constituents). This allows to account for the fact that the one or more gases entering a reaction chamber along a longitudinal direction X, impact differently on different portions of the rotating substrate (center, sides, midportions), along the transverse Y direction.

Preferably, each gas injection component includes a number N of apertures; where N is an odd integer number, preferably ≤ 9.

In one embodiment, the first conduit includes:
- a first gas injection component 150 comprising one or more apertures 150a for the injection of at least a first gas composition, and
- a second gas injection component 152 positioned downstream of the first gas injection component 150.

The second gas injection component includes one or more apertures 152a, 152b, 152c for the injection of at least a second gas composition.

A first diffusion plate 205 is positioned between the first and second gas injection components, and a second diffusion plate 205 is positioned downstream of the second gas injection component.

Two fluidically connected enclosures are thus created: a first enclosure 171 and a second enclosure 172 positioned in series along the first conduit, and fluidically connected via the first diffusion plate.

Preferably, the first gas composition is a carrier gas, such as H₂ or Ar.

Preferably, the second gas composition is a precursor composition or a doping composition, or a cleaning/etching composition.

Preferably, the flow rate I° of the first gas composition is greater than the flow rate of the second gas composition I', i.e., I° > I'.

Even more preferably, the flow rate of the first composition is at least one order of magnitude greater than the flow rate of the second gas composition. It is understood that the flow rate of the first composition can be two, three (or more) orders of magnitude greater than the flow rate of the second gas composition: I° >> I'.

In the above embodiment, the injection apparatus may further include a number M of separation plates 210.

Additionally, the second gas injection component 152 may include a number N of apertures 152a, 152b, 152c, where N ≥ 2, and M = N-1. Preferably N is an odd number (thus M is preferably an even number).

The M separation plates 210 are placed between the first and second diffusion plates 205, preferably orthogonal thereto, in order to fluidically isolate the N apertures 152a, 152b, 152c from each other.

The arrangement of the M separation plates forms M+1 (= N) fluidically uncoupled sub-enclosures within the second enclosure 172.

This allows to inject up to N different gas compositions to differently treat the substrate or the inner walls of the chamber along the Y direction, or to tailor the relative ratios or concentrations of individual gaseous elements of a same gas composition along the Y direction.

This allows to achieve different effects between the central and the peripheral parts of the substrate or the reaction chamber.

As an example, the second gas composition may be a precursor composition comprising a carrier gas and gaseous precursors; the gaseous precursors may be injected with slightly different concentration within the carrier gas in the different apertures 152a, 152b, 152c.

In one embodiment, the injection apparatus includes:
- a third gas injection component 154 positioned in the first conduit downstream of the second gas injection component 152, and
- a third diffusion plate positioned in the first conduit downstream of the second gas injection component.

This arrangement creates a third enclosure 173 downstream of the first and second enclosures.

The third gas injection component 154 includes one or more apertures 154a, 154b, 154c for the injection of at least a third gas composition.

Preferably, the third gas injection component 154 comprises a number N' of apertures 154a, 154b, 154c, with N' ≥ 2.

The injection apparatus further comprises a number M' of separation plates, with M'= N'-1.

The M' separation plates are placed between the second and third diffusion plates, in order to fluidically segregate the N' apertures from each other. See FIG. 6 and FIG. 7.

In analogy with the discussion above, the arrangement of the M' separation plates forms M'+1 fluidically uncoupled sub-enclosures within the third enclosure 173.

This allows to inject up to N' different gas compositions to differently treat the substrate or the inner walls of the chamber along the Y direction, or to tailor the relative ratios or concentrations of individual gaseous elements of a same gas composition (such as the third gas composition) along the Y direction.

As an example, the third gas composition may be a doping composition comprising a carrier gas and dopant precursors, and the latter may be injected with slightly different concentration within the carrier gas in the different apertures 154a, 154b, 154c.

These different relative concentrations of the same elements are, for simplicity, referred to collectively as third gas composition. The same expression may therefore cover these variations, which do not involve a change in the type of constituent elements. The same applies to the expressions of first gas composition, second gas composition, etc.

The above embodiment may be generalized for any number P of gas injection components and corresponding enclosures, each with its own number of apertures Nⁱ and separation plates Mⁱ = Nⁱ -1. Preferably, but not exclusively 1< P < 7, and 1≤ Ni < 9.

In one embodiment, the injection apparatus 10 further includes a movable partition 250 adapted to take a first position when one or more gases are injected in the first conduit 100 of the injection apparatus; and to take a second position when a substrate is displaced in the second conduit 200.

In the first position, the movable partition partially or completely obstructs the second conduit

In the second position, the movable partition unobstructs the hollow body of the second conduit.

Advantageously, in the first position the movable partition may:
- prevent the one or more gases from reaching the second end, and/or
- reduce turbulence and facilitate the flow of one or more gases towards the first end, and/or
- reflect the heat coming from the first end, away from the second end, when the first end is connected to a reaction chamber.

To this effect, the movable partition may be reflective on the side facing the first end; for example, it can be made of reflective quartz or other reflecting non contaminant material resistant to the reaction chamber reaction and deposition temperatures.

The movable partition may move between the first and second position for example by sliding, folding or retracting. Folding is preferred because it minimizes potential particle generation.

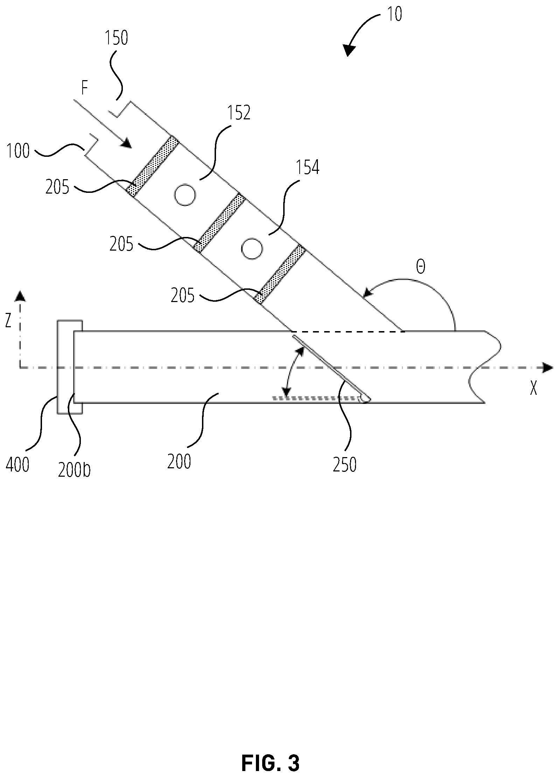

The movable partition may be hinged, connected or secured on the inner wall of the first conduit or of the second conduit. FIG. 3, FIG. 8 and FIG. 9 schematically depict the second option (the first position is sketched as a solid line, the second position as a dashed line).

Preferably, the second conduit 200 and/or the first conduit 100 are substantially made of quartz, i.e., they comprise or consist of quartz. In particular, their body and inner walls preferably comprise or consists of quartz.

Under another aspect, the invention relates to a method for delivering one or more gases inside a reaction chamber, the method comprising the following steps:
- providing the injection apparatus hereinbefore described, the injection apparatus having a plurality of gas injection components;
- injecting at least a first gas composition into a first gas injection component with a first flow rate I ' ,
- injecting at least a second gas composition into a second gas injection component with a second flow rate I' ', with I" < I', preferably I"<0.1*I'.
- optionally injecting at least a third gas composition into a second gas injection component with a third flow rate I‴, with I‴ < I', preferably I‴<0.1*I' .

The first gas composition comprises one or more gases, for example it can be a single carrier gas.

The second gas composition comprises one or more gases, and the second gas composition is different from the first.

The optional third gas composition comprises one or more gases, and the third gas composition is preferably different from both the first and the second gas composition.

Under another aspect, the invention relates to a reaction chamber 1 for the deposition of films on a substrate comprising:
- the injection apparatus 10 according to the invention,
- two lateral walls, and an upper and lower inner walls 3, defining a reaction and deposition space,
- a substrate receiving area 9 positioned on the lower inner wall and adapted to host a substrate holder,
- a thermal insulation system including one or more insulating elements 7,

The injection apparatus is connected at its first end to the reaction and deposition space, either directly or indirectly.

For example, the injection apparatus may be connected at its first end to the reaction and deposition space via an optional transition piece 500.

The transition piece" can be used for pre-heating the one or more gases. Preferably, in SiC reactors, such "transition piece" is made of graphite (optionally with a silicon carbide and/or tantalum carbide coating).

Preferably, the reaction chamber is a single substrate chamber.

For example, without limitation, the reaction chamber may be a CVD reaction chamber, and more specifically it may be an epitaxial reaction chamber.

For example, without limitation, the reaction chamber may be a SiC reaction chamber.

For example, without limitation, the reaction chamber may further comprise one or more outer walls 5.

For example, without limitation, the reaction chamber may be of the type described in international patent applications published as: WO2004053187, WO2004053188, WO2007088420 and WO2015092525.

For example, without limitation, the reaction chamber may be of the type described in US patent application No.18/953,993.

Under another aspect, the invention relates to a reactor comprising:
- at least one reaction chamber 1 as hereinbefore described, the reaction chamber being provided with a gas delivery system connected or connectable with the injection apparatus 10 according to the invention;
- a heating system adapted to heat the at least one reaction chamber to a nominal temperature;
- a vacuum system adapted to bring the reaction chamber to a nominal pressure.

In a non-limiting example, the reactor is of the horizontal, cross-flow type.

For example, it may be adapted for the deposition of silicon carbide films in one or more reaction chambers (such as 1-12 reaction chambers, preferably 1-6) .

In this case, the heating system may be adapted to heat the reaction and deposition space of the reaction chamber to a temperature up to 1700°C, and specifically to a temperature of 1400 °C - 1650 °C.

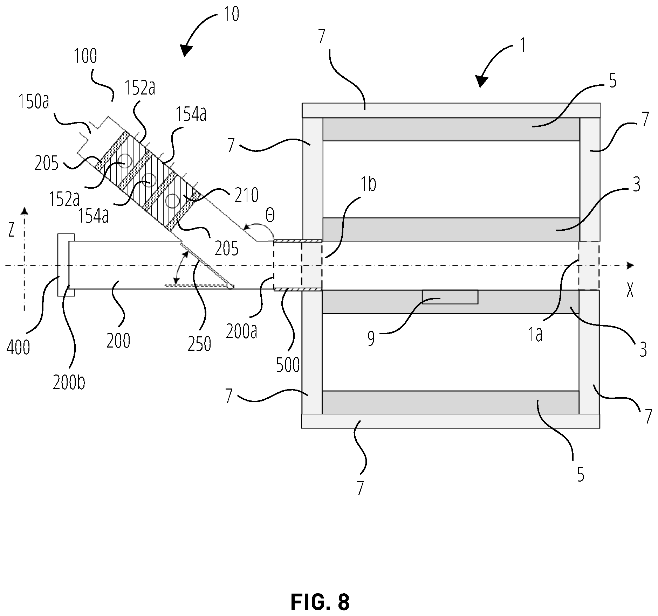

In a non-limiting example, the walls of the reaction chamber, such as the inner walls 3 and/or outer walls 5 of the embodiment of FIG. 8 are made of a susceptive material, such as graphite, and the heating system may be an induction system.

The vacuum system may be adapted to depressurize the reaction and deposition space of the reaction chamber to 1000 mbar or lower, preferably to 100 - 1000 mbar.

Under an embodiment, the reactor hereinbefore described is configured to execute the method according to the invention.

### DESCRIPTION OF THE FIGURES

FIG. 1 schematically illustrates a top view of an injection apparatus 1000 of the prior art in the XY plane.

The injection apparatus consists of single conduit 1100, three inlets 1150 for the injection of one or more gases towards a first end 1100a, connected or connectable to a reaction chamber (not shown).

The system comprises two separation plates 210, which define three fluidically segregated enclosures 1110a, 1110b, 1110c, adapted to receive a gas composition, with at least one flow rate I°.

Because of the separation plates 210, the injection system 1000 does not allow to displace a substrate, alone or on a substrate holder, along the conduit 1100, in order to upload/download the substrate to/from the reaction chamber.

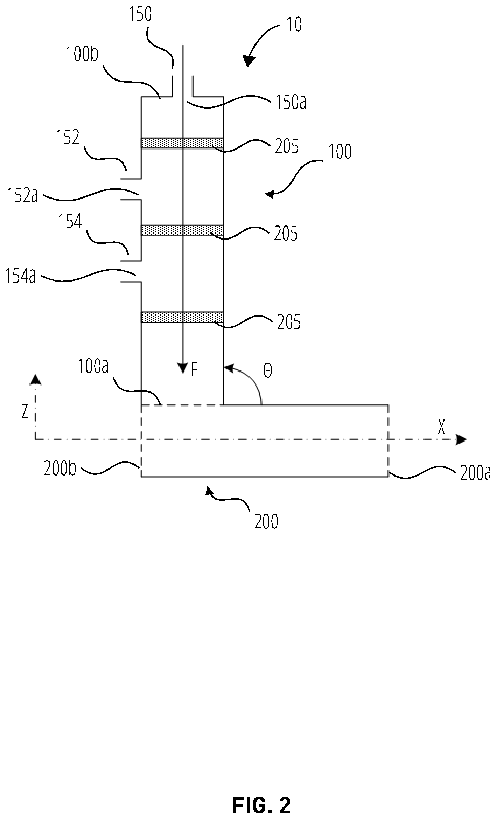

FIG. 2 schematically illustrates a lateral view of an injection apparatus 10 in the XZ plane, according to an embodiment of the invention.

The Y direction, perpendicular to the XZ plane, is not shown.

The injection apparatus 10 comprises a first conduit 100 connected to a second conduit 200 at an angle θ = 90°.

The first conduit 100 is a hollow body, comprising: (a) a first gas injection component 150 with an aperture 150a; (b) a second gas injection component 152 with an aperture 152a; and (c) a third gas injection component 154 with an aperture 154a.

The first, second and third gas injection components are sequentially placed along the first conduit, with a diffusion plate 205 positioned downstream of each gas injection components.

The gases from the gas injection components follow a main direction of gas flow F along the hollow body of the first conduit 100, from an upstream end 100b to a downstream end 100a.

The first conduit 100 and the second conduit 200 are fluidically connected in correspondence of the downstream end of first conduit, through an opening.

The second conduit 200 terminates on one side in the X direction at a first end 200a, which is an opening connected or connectable to a reaction chamber (not shown).

The second conduit 200 terminates at the other side on a second end 200b, which is an opening connected or connectable to gate valve (not shown) or other means to releasably close the opening.

FIG. 3 schematically illustrates a lateral view of an injection apparatus 10 in the XZ plane, according to an embodiment of the invention.

The Y direction, perpendicular to the XZ plane, is not shown.

The injection apparatus 10 comprises a first conduit 100 and a second conduit 200 connected at an angle θ of roughly 135°.

The first conduit 100 comprises: a first gas injection component 150, a second gas injection component 152, and a third gas injection component 154, sequentially placed along the main direction of gas flow F. Each gas injection component has a diffusion plate 205 placed downstream, before the next gas injection component, if present, or before the downstream end of the first conduit.

The second conduit 200 extends along the longitudinal direction X, from a second end 200b, equipped with a gate valve 400.

The second conduit features an opening along its body (dash line), at its downstream end, where it fluidically connects to the first conduit.

Compared to FIG. 2, keeping the inclination of the second conduit with respect to the first conduit to an angle θ within a range of 165°-105° or 15°- 75° allows to reduce turbulence in the gas flow.

This desirable effect is further improved by the movable partition 250, which is placed in the illustrated first position.

The movable partition is adapted to intercept the gas flow from the first conduit and to direct it towards the first end, opposite to the second end 200b.

To this effect, the movable partition may also feature a non-planar profile.

The movable partition 250, may also fold towards the inner wall of the second conduit in a second position (dashed line), to allow a displacement of a substrate (with or without a substrate holder, and with or without a robotic arm attached thereto).

The movable partition 250 is a quartz element having a reflective surface facing the first end of the second conduit (not shown).

The movable partition 250 further screens the second end 200b from heat coming from a reaction chamber (not shown) connectable to the first end.

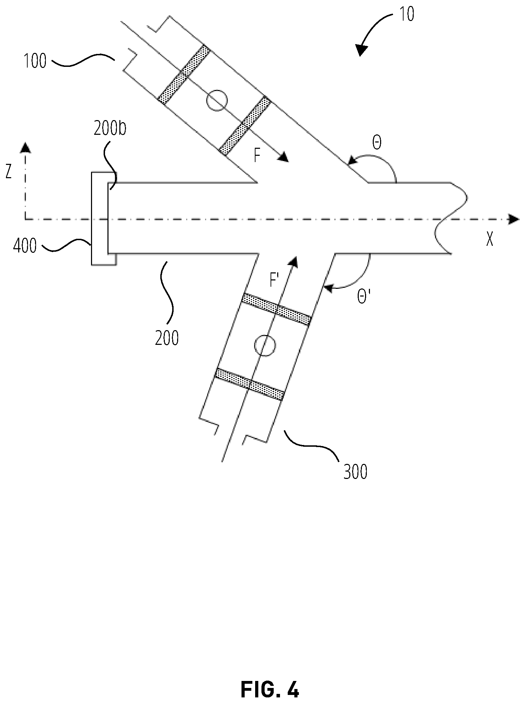

FIG. 4 schematically illustrates a lateral view of an injection apparatus 10 in the XZ plane, according to an embodiment of the invention.

The Y direction, perpendicular to the vertical XZ plane, is not shown.

The injection apparatus 10 comprises a first conduit 100, a second conduit 200 (having a second end 200b, which is closed by a gate valve 400), and a third conduit 300.

The present embodiment demonstrates how the present invention may comprise a plurality of conduits connected to the second conduit 200, at different angles θ, θ',..., with each conduit comprising its own gas injection components, separately directing one or more gases towards the second conduit along different directions of gas flow F, F', ....

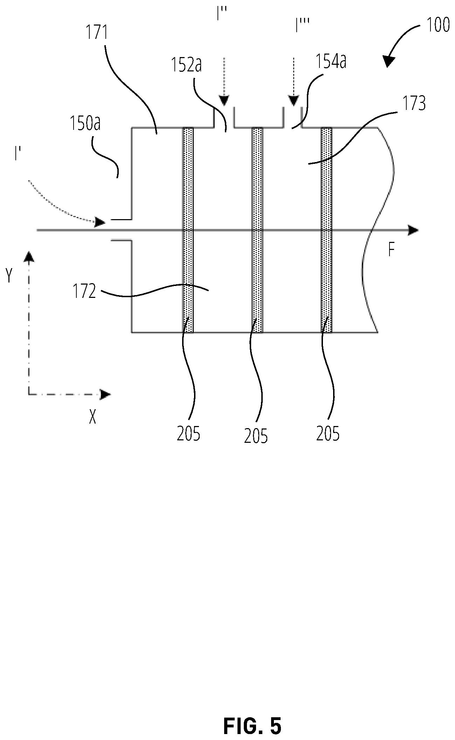

FIG. 5 schematically illustrates a top view of a first conduit 100 projected in the XY plane, according to an embodiment of the invention.

The Z direction, perpendicular to the XZ plane, is not shown.

The first conduit 100 comprises three apertures 150a, 152a, 154a, each upstream of a diffusion plate 205, and adapted to respectively flow: (i) a first composition with a first flow rate I', (ii) a second composition with a second flow rate I'', and (iii) a third composition with a third flow rate I''', with I''< I' and I'''< I'.

The diffusion plates and the inner walls of the first conduit define three enclosures: a first enclosure 171, a second enclosure 172, and a third enclosure 173, fluidically coupled to each other.

FIG. 6 and FIG. 7 schematically illustrates a top view of one same first conduit 100 projected in the XY plane, according to an embodiment of the invention, with different elements referenced in the two Figures for clarity.

The Z direction, perpendicular to the XZ plane, is not shown.

The first conduit 100 comprises three gas injection components. Going from upstream to downstream in the main direction of gas flow F, the first gas injection component 150 comprises one aperture 150a for the injection of a first gas composition, such as a carrier gas, and is followed by a diffusion plate 205, which creates a first enclosure 171.

The second gas injection component 152 comprises three apertures (152a, 152b, and 152c) for the injection of a second gas composition and is followed by a diffusion plate 205, which creates a second enclosure 172.

Two separation plates 210 further divide the second enclosure 172 into three sub-enclosures, which are not in fluidic communication with each other within the enclosure 172.

This segregation allows to slightly modify the second composition, which may be a precursor composition, depending on its spatial position in the Y direction.

This allows to tailor the process gases concentration/ratio based on their peripheral or central position with respect to a substrate, when the latter is placed in a reaction chamber connected to the injection apparatus.

The third gas injection component 154 comprises three apertures (154a, 154b, 154c) for the injection of a third gas composition, for example a doping composition, and is followed by a diffusion plate 205, which creates a third enclosure 173.

Two separation plates 210 further divide the third enclosure into three sub-enclosures, which are not in fluidic communication with each other within the enclosure 173.

The three enclosures 171, 172, 173 are fluidically connected with each other along the main direction of gas flow F through the diffusion plates 205, which allow the gas compositions exiting each enclosure to have uniform speed across the Y direction, thereby minimizing turbulence and minimizing crossmixing of the compositions exiting the sub-enclosures, if present, with each other.

While this embodiment shows three enclosures, with the last two featuring three sub-enclosures, it is noted that the number of enclosures (and gas injection components) and the number of sub-enclosures (and apertures and separation plates) may vary.

The preferred number of enclosures (and gas injection components) may be selected based on the number of different gas compositions and gas lines that are supposed to be used in the operation of the reactor, and whether based on the chemical constituents of the gas compositions it is advisable to use separate injection lines.

Analogously, the number of sub-enclosures (and apertures and separation plates), may be determined based on the reaction chamber design, substrate size, and film chemistry used.

These parameters determine how critical, for a given gas composition, is the gas composition profile in the transverse plane YZ. In general, it is preferable to use an odd number of sub-enclosures, to discriminate the central area of the substrate from the remaining area(s).

FIG. 8 schematically illustrates a lateral view of a reaction chamber 1 in the XZ plane, according to an embodiment of the invention.

The reaction chamber 1 is in a horizontal, cross flow configuration, with the horizontal plane coinciding with the XY plane.

The reaction chamber 1 comprises: an injection apparatus 10, a plurality of inner walls 3 defining the space where the reaction and deposition takes place, a plurality of outer walls 5, a thermal insulating assembly comprising a plurality of insulating elements 7, and a transition piece 500.

The transition piece 500 fluidically connects the first end 200a of the second conduit of the injection apparatus 10 with the space where the reaction and deposition takes place. The connection allows one or more gases injected into the first conduit 100 of the injection apparatus 10, to reach the substrate receiving area 9 placed on the bottom inner wall 3.

The injection of gases takes place along the first conduit, between its upstream side 1b and its downstream side 1a.

The first conduit is designed in accordance with the embodiments illustrated in FIG. 6 and FIG. 7.

The second conduit presents a movable partition 250, which operates as discussed in FIG. 3.

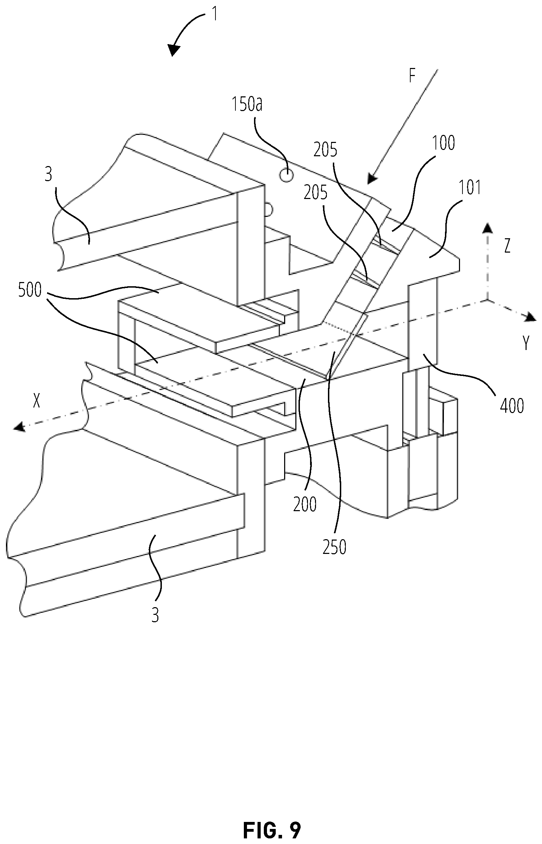

FIG. 9 presents a schematic axonometric view of a cropped section of a reaction chamber 1 in a XYZ space, according to an embodiment of the invention.

The system comprises a first conduit 100 with an injection component having an aperture 150a, and diffusion plates 205.

The first conduit 100 abuts onto a second conduit 200, fluidically connected thereto.

The second conduit can be closed at its second end by the gate valve 400.

A movable partition 250 eases the gas flow F into the second conduit 200.

The first end of the second conduit is fluidically connected to the reaction and deposition space of the reaction chamber via the transition piece 500. The reaction and deposition space of the reaction chamber is delimited by the inner walls 3.

This embodiment shows how the bodies of the first conduit and of the second conduit can be integrated with one another and have some exterior parts in common, such as the outer body part 101, which is shared between the bottom body of the first conduit 100, and a section of the upper body of the second conduit 200.

While it is generally advantageous for the first conduit and second conduit to extend linearly across a given direction (the longitudinal direction X for the second conduit, and a nominal direction of gas flow F for the first conduit), it is understood that these hollow bodies may feature curvatures and/or changes in direction, without departing from the scope of the invention.

In these cases, the directions of reference will be the tangents at the relevant points, for example: at the connection between the first conduit and second conduit, at the first end and at the second end, at the upstream and downstream ends.

It is nevertheless suggested to have at least the hollow second conduit extend linearly, along one same direction X, and have its cavity essentially unobstructed, except for the optional movable partition.

It is noted that in general, even if not shown in the figures, each gas injection component may optionally comprise one or more inlets, nozzles and/or other suitable elements, which, alone or in combination, may be adapted to efficiently and safely deliver one or more gases from one or more gas lines of a reactor gas delivery system to the first conduit, through the one or more apertures of each gas injection component.

It is also noted that the gas lines of gas delivery system of a reactor may be connected or connectable to a gas source or a vessel.

The subject matter of the present disclosure includes all novel and nonobvious combinations and subcombinations of the various processes, systems, and configurations, and other features, functions, acts, and/or properties disclosed herein, as well as any and all equivalents thereof.

## Claims

1. An injection apparatus (10) for delivering one or more gases inside a reaction chamber (1) for the deposition of films on a substrate, the injection apparatus comprising:
- a first conduit (100) comprising at least one gas injection component (150, 152, 154); and
- a second conduit (200) fluidically connected to said first conduit (100) and having a hollow body extending along a longitudinal direction X; and
- at least one diffusion plate (205);
wherein the first conduit is connected to the second conduit so as to form an angle θ with respect to the second conduit, with 0 < θ < 180°; and
wherein the at least one gas injection component comprises one or more apertures (150a, 152a, 152b, 152c, 154a, 154b, 154c) for the injection of one or more gases inside the first conduit, the first conduit being suited to flow said one or more gases into the second conduit; and
wherein the body of the second conduit has a first end (200a) and a second end (200b) along the longitudinal direction X, the first end being fluidically connectable to a reaction chamber (1); and
wherein the second conduit is suitable for receiving the one or more gases from the first conduit and delivering them towards the first end; the second conduit being suitable for the displacement of one or more substrates between its first end and its second end; and
wherein the at least one diffusion plate is positioned across the first conduit and downstream of at least one of the one or more apertures for the injection of one or more gases.

2. The injection apparatus (10) of claim 1, further comprising:
- a plurality of gas injection components sequentially placed along the first conduit; and
- a plurality of diffusion plates;
wherein at least one diffusion plate is placed downstream of each gas injection component; and
wherein each successive gas injection component is positioned downstream with respect to the preceding one, thereby forming a sequence of enclosures (171, 172, 173) fluidically connected in series along the first conduit; and
wherein each enclosure is delimited by the internal walls of the first conduit, or a portion thereof, and by one or more diffusion plates; and
wherein each gas injection component comprises one or more apertures for the injection of one or more gases, and each gas injection component is adapted to inject the one or more gases into one enclosure.

3. The injection apparatus (10) of claim 2, further comprising at least one separation plate (210); and
wherein at least one gas injection component comprises at least two apertures placed on one same enclosure; and
wherein the at least one separation plate is arranged into said one same enclosure so as to fluidically segregate the at least two apertures from each other.

4. The injection apparatus (10) of claim 2 or 3, wherein each gas injection component comprises a number N of apertures; wherein N is an odd integer number, with N preferably lower or equal to 9.

5. The injection apparatus (10) of any one of claims 1 to 4, further comprising:
- a first gas injection component (150) positioned in the first conduit and comprising one or more apertures (150a) for the injection of at least a first gas composition; and
- a second gas injection component (152) positioned in the first conduit downstream of the first gas injection component; the second gas injection component comprising one or more apertures (152a, 152b, 152c) for the injection of at least a second gas composition; and
- at least two diffusion plates, with at least one diffusion plate positioned in the first conduit downstream of each gas injection component.

6. The injection apparatus (10) of claim 5, wherein the second gas injection component comprises a number N of apertures, with N ≥ 2; the injection apparatus further comprising a number M of separation plates, with M = N-1;
wherein the M separation plates are placed between the first and second diffusion plates, in such a way as to fluidically segregate the N apertures from each other.

7. The injection apparatus (10) of claim 6, further comprising:
- a third gas injection component (154) positioned in the first conduit, downstream of the second gas injection component, and comprising one or more apertures (154a, 154b, 154c) for the injection of at least a third gas composition; and
- a third diffusion plate positioned in the first conduit, downstream of the third gas injection component.

8. The injection apparatus (10) of claim 7, wherein the third gas injection component comprises a number N' of apertures, with N' ≥ 2, the injection apparatus further comprising a number M' of separation plates, with M'= N'-1;
wherein the M' separation plates are placed between the second and third diffusion plates, in order to fluidically segregate the N' apertures from each other.

9. The injection apparatus (10) of any one of claims 1 to 8, further comprising a movable partition (250) adapted to take a first position when one or more gases are injected in the first conduit of the injection apparatus; and to take a second position when a substrate is displaced in the second conduit;
wherein:
- in the first position the movable partition partially or completely obstructs the second conduit; and
- in the second position the movable partition unobstructs the hollow body of the second conduit.

10. The injection apparatus (10) of any one of claims 1 to 9, wherein the second conduit and/or the first conduit comprise or consist of quartz.

11. A method for delivering one or more gases inside a reaction chamber (1), the method comprising the following steps:
- providing the injection apparatus (10) according to any one of claims 2 to 8;
- injecting at least a first gas composition into a first gas injection component (150) with a first flow rate (I');
- injecting at least a second gas composition into a second gas injection component (152) with a second flow rate (I'');
wherein the first gas composition comprises one or more gases, such as, preferably, a single carrier gas;
wherein the second gas composition comprises one or more gases, with the second gas composition being different from the first;
wherein the second flow rate is lower than the first flow rate, preferably at least one order of magnitude lower.

12. A reaction chamber (1) for the deposition of films on a substrate comprising:
- the injection apparatus (10) according to any one of claims 1 to 10;
- two lateral walls, and an upper and a lower inner wall (3) defining a reaction and deposition space;
- a substrate receiving area (9) positioned on the lower inner wall and adapted to lodge a substrate holder;
- a thermal insulation system comprising one or more insulating elements (7);
- the injection apparatus being connected to the reaction and deposition space, either directly or indirectly via an optional transition piece (500).

13. A reactor comprising:
- at least one reaction chamber (1) according to claim 12, said reaction chamber being provided with a gas delivery system connected or connectable with the injection apparatus (10);
- a heating system adapted to heat the at least one reaction chamber to a nominal temperature;
- a vacuum system adapted to bring the reaction chamber to a nominal pressure.

14. The reactor according to claim 13, wherein said reactor is configured to execute the method according to claim 11.
